# DEMANDE DE BREVET EUROPEEN

(11) **EP 1 257 158 A1**
(43) Date de publication de la demande: **13.11.2002**
(21) Numéro de dépôt: 02076785.1
(22) Date de dépôt: 06.05.2002
(51) Int. Cl.: H05K 5/00, H04M 1/02, H04B 1/08

(54) **Boitier de protection d'un appareil électronique, procédé et outillage de fabrication d'un tel boitier**

(30) Priorité: 10.05.2001 FR 0106199
(71) Demandeur: Koninklijke Philips Electronics N.V., 5621 BA Eindhoven (NL)
(72) Inventeur: Cheynet, Joseph, 75008 Paris (FR); Grandbert, Anthony, 75008 Paris (FR); Mozer, Laurent, 75008 Paris (FR)
(74) Mandataire: Chaffraix, Jean

(57) **Abrégé**

L'invention propose un boîtier de protection (12) d'un appareil électronique (10) du type qui comporte une coque (18) dans laquelle est réalisée une ouverture (20) obturée par un corps (22) en matière transparente de forme générale plane, du type dans lequel au moins une zone annulaire périphérique interne de fixation (30) du corps (22) transparent est fixée sur une zone (32) en vis-à-vis de la périphérie de l'ouverture (20) par des moyens de fixation et/ou de positionnement (34) avec interposition d'un premier revêtement de décoration (38) entre la zone périphérique (30) de fixation du corps (22) transparent et les moyens de fixation et/ou de positionnement (34), caractérisé en ce que la zone périphérique de fixation (30) est inclinée par rapport au plan général du corps (22) transparent.

L'invention propose aussi un procédé et un outillage de fabrication d'un tel boîtier.

## Description

L'invention propose un boîtier de protection d'un appareil électronique.

L'invention propose plus particulièrement un boîtier de protection d'un appareil électronique du type qui comporte une coque dans laquelle est réalisée une ouverture obturée par un corps en matière transparente de forme générale plane.

L'invention propose encore un appareil électronique comportant un tel boîtier.

De tels boîtiers de protection sont par exemple utilisés pour des téléphones mobiles de type GSM.

Le boîtier de protection permet bien entendu de protéger les composants de l'appareil électronique tels qu'un clavier de touches et des commutateurs dont l'activation modifie l'état électrique d'un circuit de commande. Dans le cas d'un téléphone mobile, le boîtier de protection doit notamment protéger aussi un écran d'affichage qui permet de réaliser l'interface entre l'appareil et l'utilisateur.

Pour ce faire, le boîtier comporte une ouverture ou fenêtre qui est obturée par un corps en matière transparente de forme générale plane. L'écran d'affichage est alors agencé à l'intérieur du boîtier en vis-à-vis de l'ouverture.

Dans certains cas, le corps en matière transparente présente des propriétés optiques particulières telles qu'un effet grossissant qui permet alors d'améliorer la lisibilité des informations affichées sur l'écran d'affichage.

Le corps en matière transparente doit être suffisamment résistant pour protéger l'écran d'affichage contre des chocs ou des rayures qui peuvent être dues aux frottements de l'appareil électronique contre d'autres objets, par exemple des clés métalliques, lorsqu'il est placé à l'intérieur d'un sac à main.

Ainsi, les dimensions du corps en matière transparente, notamment son épaisseur, ainsi que ses caractéristiques, notamment la dureté de sa face externe, sont déterminées de façon à résister aux chocs et aux rayures.

Pour ce faire, il est connu d'utiliser un corps en matière plastique dont l'épaisseur est de l'ordre de 2 à 5 mm et dont la face externe est recouverte d'un revêtement de protection anti-rayures qui augmentent la dureté superficielle de la face externe du corps.

La fixation du corps transparent sur le boîtier est généralement réalisée par collage d'une zone périphérique du corps transparent, qui est orientée vers l'intérieur du boîtier, sur une zone périphérique de l'ouverture qui est avantageusement située à l'intérieur du boîtier de façon que la face externe du boîtier et la face externe du corps transparent soient sensiblement alignées ou affleurantes.

Dans ce cas, de la colle est visible depuis l'extérieur du boîtier à travers le corps en matière plastique. Cela est préjudiciable à l'esthétique du téléphone.

De façon à masquer la colle, un revêtement de décoration peut être déposé sur la face externe du corps en matière transparente avant que cette face soit recouverte du revêtement de protection.

Cependant, lorsque le revêtement de protection n'est pas suffisamment résistant pour protéger le corps en matière transparente, le revêtement de décoration peut être rayé.

La distance qui sépare l'écran d'affichage et le revêtement de décoration qui est de l'ordre de plusieurs millimètres provoque une impression d'éloignement de l'écran vers l'intérieur du boîtier. Cette impression est préjudiciable à l'allure générale de l'appareil électronique.

De plus, lorsque la lumière extérieure au boîtier éclaire celui-ci selon une direction qui n'est pas perpendiculaire au plan général du corps en matière transparente, le revêtement de protection provoque la formation d'ombres sur l'écran qui gênent la lecture des informations fournies par l'écran.

Pour remédier à ces problèmes, il est connu que le revêtement de décoration soit interposé entre la zone de fixation du corps transparent et la colle de fixation.

Cependant, il n'est pas possible de déposer concomitamment le revêtement de protection et le revêtement de décoration sur leurs zones respectives situées sur des faces opposées du corps transparent.

De façon que le revêtement de décoration fournisse un effet esthétique positif, il doit être déposé sur une surface plane. Or, la planéité de la face intérieure du corps transparent n'est pas toujours suffisante. Cela provoque des irrégularités du revêtement qui sont visibles par l'utilisateur.

Lorsque l'épaisseur du corps transparent est de l'ordre de quelques millimètres, l'utilisateur peut voir à travers les faces latérales du corps, ce qui est préjudiciable à l'allure générale de l'appareil électronique.

De façon à résoudre ces problèmes, l'invention propose un boîtier de protection d'un appareil électronique du type qui comporte une coque dans laquelle est réalisée une ouverture obturée par un corps en matière transparente de forme générale plane, du type dans lequel au moins une zone annulaire périphérique intérieure de fixation du corps transparent est fixée sur une zone en vis-à-vis de la périphérie de l'ouverture par des moyens de fixation et/ou de positionnement avec interposition d'un premier revêtement de décoration entre la zone périphérique de fixation du corps transparent et les moyens de fixation et/ou de positionnement,
caractérisé en ce que la zone périphérique de fixation est inclinée par rapport au plan général du corps transparent.

Selon d'autres caractéristiques de l'invention :
- la zone périphérique de fixation inclinée s'étend sur la totalité du pourtour du corps transparent ;
- la face externe sensiblement plane du corps transparent est revêtue au moins partiellement d'un deuxième revêtement, notamment un revêtement de protection, par exemple antirayures, de la face externe du corps transparent ;
- les moyens de fixation et/ou de positionnement comportent une couche de colle ;
- les moyens de fixation et/ou de positionnement comportent au moins un insert, et le premier revêtement masque au moins partiellement l'insert ;
- l'angle d'inclinaison de la zone périphérique de fixation est de l'ordre de 30° par rapport au plan général du corps transparent.

L'invention propose aussi un procédé de fabrication d'un boîtier de protection du type décrit précédemment, caractérisé en ce que : on réalise l'insert par moulage d'une première matière dans une première cavité, délimitée par les empreintes de deux matrices d'un premier moule ; puis on transfère l'insert dans une deuxième cavité, délimitée par les empreintes de deux matrices d'un deuxième moule, dans laquelle on injecte une seconde matière transparente de façon à réaliser le corps transparent par surmoulage de la deuxième matière sur l'insert.

Selon d'autres caractéristiques du procédé :
- lors de la réalisation de l'insert, le premier revêtement de décoration est déposé sur la zone de l'insert complémentaire de la zone périphérique de fixation du corps transparent, par transfert du premier revêtement de décoration qui appartient à un film qui s'étend dans la cavité du premier moule ;
- lors du surmoulage du corps transparent, le deuxième revêtement est déposé sur au moins une partie de la face externe du corps par transfert du deuxième revêtement qui appartient à un film qui s'étend dans la cavité du deuxième moule.

L'invention propose encore un outillage pour la fabrication d'un boîtier de protection du type qui comporte :
un premier moule constitué d'une première matrice inférieure et d'une première matrice supérieure comportant chacune une empreinte de façon à délimiter une première cavité dans laquelle est réalisé l'insert,
et un deuxième moule constitué d'une deuxième matrice inférieure et d'une deuxième matrice supérieure comportant chacune une empreinte de façon à délimiter une deuxième cavité dans laquelle est transféré l'insert sur lequel le corps transparent est surmoulé,
caractérisé en ce que la première matrice inférieure et la deuxième matrice inférieure comportent chacune une empreinte identique.

Selon d'autres caractéristiques de l'outillage :
- les première et deuxième matrices inférieures sont mobiles par rapport aux première et deuxième matrices supérieures ;
- les première et deuxième matrices supérieures sont réalisées en une matrice supérieure commune comportant deux empreintes, les première et deuxième matrices inférieures sont réalisées en une matrice inférieure commune comportant deux empreintes et une matrice commune est montée pivotante autour d'un axe orthogonal au plan de joint des moules de façon que son pivotement de 180° permette la coopération alternative de chacune de ces deux empreintes avec chacune des empreintes des deux autres matrices.

D'autres caractéristiques et avantages de l'invention apparaîtront à la lecture de la description détaillée qui suit pour la compréhension de laquelle on se reportera aux dessins annexés parmi lesquels :
- la figure 1 est une vue schématique en coupe transversale d'un boîtier de protection selon une première réalisation de l'état de la technique ;
- la figure 2 représente à grande échelle un détail de la figure précédente ;
- la figure 3 est une vue en coupe transversale d'un boîtier de protection selon une deuxième réalisation de l'état de la technique ;
- la figure 4 représente à grande échelle un détail de la figure précédente ;
- la figure 5 est une vue en coupe transversale d'un boîtier de protection selon un premier mode de réalisation de l'invention ;
- la figure 6 représente à grande échelle un détail de la figure précédente ;
- la figure 7 est une vue en coupe transversale à plus grande échelle d'une partie d'un boîtier de protection selon un deuxième mode de réalisation de l'invention ;
- la figure 8 est une vue schématique en perspective d'un outillage pour la fabrication d'un boîtier de protection selon l'invention ;
- les figures 9A à 9F sont des vues en coupe de l'outillage représenté à la figure précédente qui illustre les étapes successives du procédé de fabrication du boîtier de protection réalisé selon l'invention.

Dans la description qui suit les éléments identiques ou similaires seront désignés par les mêmes chiffres de référence.

On adaptera, à titre non limitatif, une terminologie horizontale, verticale, supérieure et inférieure en référence aux figures.

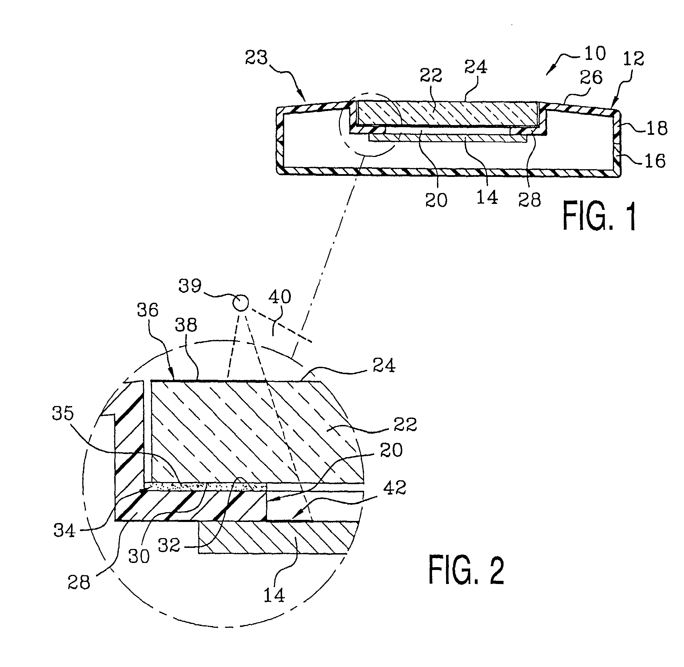

On a représenté aux figures 1 à 4 deux exemples de réalisation selon l'état de la technique d'un appareil électronique 10, qui est ici par exemple un téléphone mobile du type GSM.

Le téléphone 10 comporte un boîtier de protection 12 dans lequel sont agencés les composants qui permettent le fonctionnement du téléphone. Parmi ces éléments seul un écran d'affichage 14 est représenté.

De façon à faciliter la compréhension de la description on utilisera une orientation interne et externe par rapport à l'intérieur et à l'extérieur du boîtier de protection 12, respectivement.

Pour faciliter le montage des composants, le boîtier de protection 12 comporte une coque inférieure 16 et une coque supérieure 18 distinctes. Ainsi les éléments y sont montés puis les deux coques sont assemblées entre elles de façon à fermer le boîtier 12.

La coque supérieure 18 comporte une ouverture ou fenêtre 20 qui est obturée par un corps en matière transparente 22 de forme générale plane. L'ouverture 20 est réalisée dans la face avant ou principale 23 d'orientation sensiblement horizontale du téléphone 10.

De façon à permettre l'unité esthétique du téléphone 10, la face externe 24 de corps en matière transparente 22 est dans le prolongement de la face externe 26 de la coque supérieure 18.

La périphérie de l'ouverture 20 comporte un rebord étagé 28 qui s'étend à l'intérieur du boîtier 12 et qui reçoit le corps en matière transparente 22.

La fixation du corps 22 sur la coque supérieure 18 est obtenue par des moyens de fixation 34.

Ici, la fixation du corps 22 sur la coque 18 est obtenue par collage de la zone annulaire périphérique interne et inférieure de fixation 30 du corps 22 sur une zone supérieure 32 en vis-à-vis du rebord 28 de la périphérie de l'ouverture 20.

Ainsi, une couche de colle 35 est disposée entre la zone annulaire 30 du corps en matière transparente 22 et la zone de fixation 32 de la coque supérieure 18.

De façon à masquer les moyens de fixation 34, une zone annulaire périphérique 36 de la face externe 24 du corps 22 est recouverte d'un premier revêtement de décoration 38. Ainsi, lorsque l'utilisateur regarde la face principale 23 du téléphone 10, le premier revêtement de décoration 38 masque le rebord 28 et la couche de colle 35.

Cependant, une telle réalisation présente des inconvénients déjà cités.

Il s'agit notamment de l'impression d'éloignement de l'écran 14 vers l'intérieur du boîtier 12 et de la formation d'ombres sur l'écran d'affichage 14.

En effet, lorsque la lumière extérieure du boîtier 12 éclaire celui-ci selon une direction qui n'est pas perpendiculaire au plan général de la face principale 23 du boîtier 12, notamment à la face externe 24 du corps 22 en matière transparente, le revêtement de décoration 38 forme des ombres sur l'écran qui gênent la lecture des informations qu'il fournit.

La figure 2 représente ce phénomène. Une source lumineuse 39 émet un faisceau de lumière 40 qui est incliné par rapport à la face externe 24 du corps 22. Une partie du faisceau de lumière 40 est bloquée par le revêtement de décoration 38 et une zone d'ombre 42 est formée sur l'écran d'affichage 14 du téléphone.

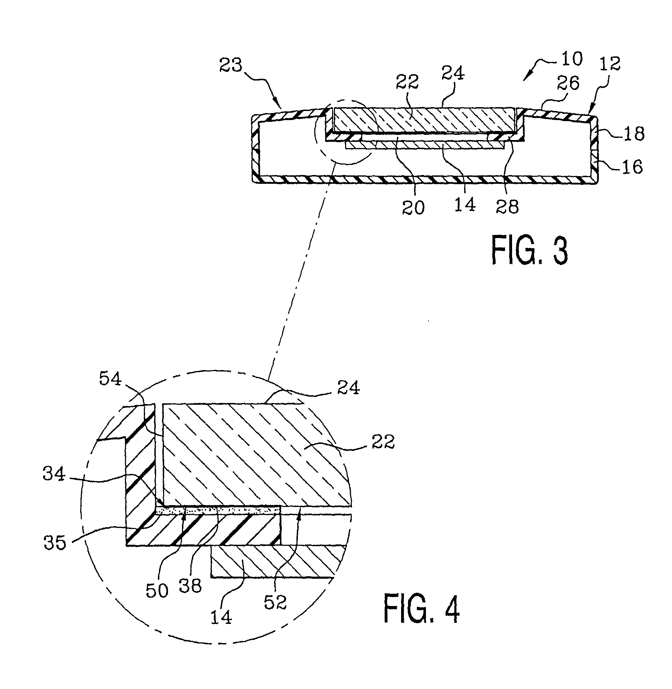

Selon un deuxième exemple de réalisation, il est aussi connu, conformément aux figures 3 et 4, que le premier revêtement de décoration 38 recouvre une zone périphérique 50 de la face inférieure interne 52 du corps 22.

Ainsi, la couche de colle 35 qui est interposée entre le premier revêtement de décoration 38 et le rebord 28, n'est pas visible de l'extérieur du téléphone 10.

Cependant, lorsque le corps 22 est épais, l'utilisateur peut "voir" à travers ses faces latérales 54, ce qui est préjudiciable à l'aspect esthétique du téléphone 12.

De plus, la distance entre la face externe 24 du corps 22 et le premier revêtement de décoration 38 donne une impression d'éloignement du premier revêtement de décoration 38 et de l'écran d'affichage 14, ce qui est préjudiciable à l'allure générale du téléphone 10.

Il est donc préférable de limiter l'épaisseur du corps 22.

Or, une réduction de l'épaisseur ne permet pas au corps de résister à tous les chocs auxquels il peut être soumis. Par conséquent il faut trouver un compromis qui permet de préserver l'esthétique du téléphone 10 et qui permet au corps 22 de résister au maximum aux chocs.

De façon à fournir une solution à ces problèmes, l'invention propose que la zone périphérique de fixation 30 soit inclinée par rapport au plan général du corps transparent 22, notamment par rapport à sa face externe 24.

L'angle ∝ d'inclinaison de la zone périphérique de fixation 30 par rapport au plan général sensiblement horizontal du corps transparent 22 peut par exemple être compris entre 15 et 30°.

Ainsi, quelle que soit l'épaisseur du corps 22 en matière transparente, la zone périphérique de fixation 30 inclinée supprime l'impression de profondeur de l'écran d'affichage 14 à l'intérieur du boîtier 12.

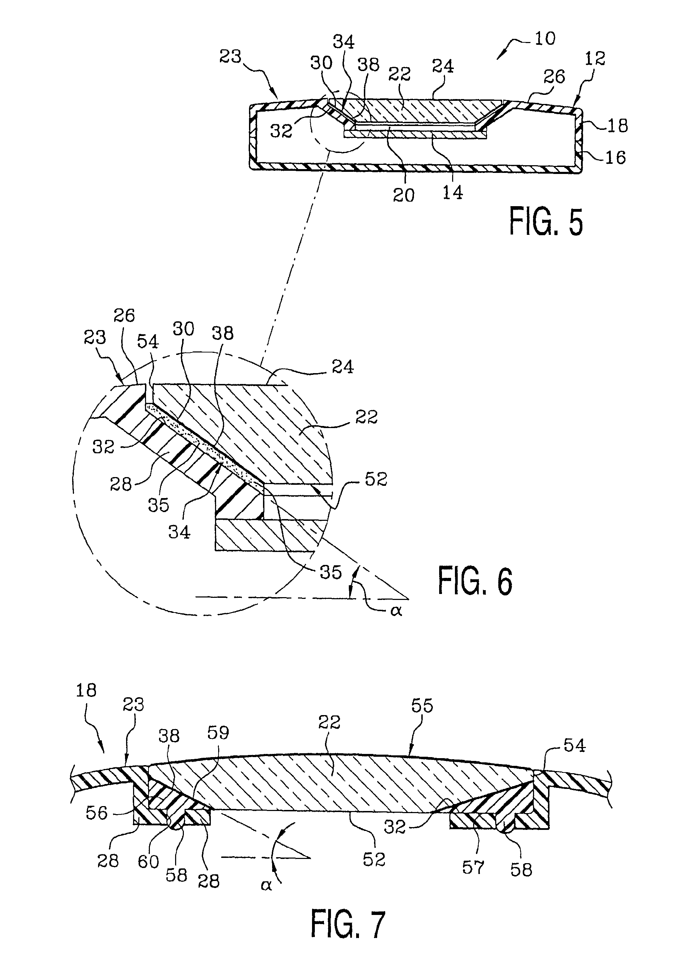

Selon un premier mode de réalisation de l'invention représenté aux figures 5 et 6, le rebord 28 de la coque supérieure 18 est incliné d'un angle ∝ identique à celui de la zone périphérique de fixation 30.

Conformément à l'état de la technique, le corps 22 en matière transparente est fixé sur la coque supérieure 18 par des moyens de fixation 34 qui comportent par exemple une couche de colle 35 avec interposition d'un premier revêtement de décoration 38 de façon à masquer la couche de colle 35 depuis l'extérieur.

Avantageusement, la zone périphérique de fixation 30 inclinée est annulaire et s'étend sur la totalité du pourtour, par exemple rectangulaire à angles arrondis, du corps 22 en matière transparente. Cela permet d'assurer l'unité esthétique du corps 22 et du téléphone 10.

Le premier revêtement de décoration 38 s'étend sensiblement de la face externe 26 de la coque supérieure 18 jusqu'à l'écran d'affichage 14 de façon à donner une impression de continuité entre la face principale 23 du téléphone 10 et l'écran d'affichage 14, ce qui améliore l'esthétique du téléphone 10.

De plus, comme on peut voir en comparant les figures 4 et 6, les faces latérales 54 du corps 22 sont très réduites. Ainsi, l'utilisateur de l'appareil ne peut pas voir le rebord 28 de la partie supérieure de la coque 18 à travers le corps 22. Cela permet d'améliorer encore l'esthétique du téléphone 10.

Avantageusement, selon une variante non représentée, la zone périphérique de fixation 30 s'étend depuis la face interne 52 jusqu'à la face externe 24 du corps 22 de façon à supprimer les faces latérales 54 et renforcer l'impression de continuité entre la face principale du téléphone 10 et l'écran d'affichage 14.

Une telle réalisation permet de supprimer tout risque de formation d'ombres sur l'écran d'affichage 14, quel que soit l'angle d'incidence de la lumière par rapport à la face principale 23 du téléphone 10.

De plus, le premier revêtement de décoration 38 étant situé entre le corps 22 en matière transparente et le rebord 28 de la coque supérieure 18, il est parfaitement protégé et ne risque en aucun cas d'être détérioré par des agressions extérieures telles que le frottement de la face principale 23 avec d'autres objets.

La face externe 24 du corps 22 peut être revêtue d'un deuxième revêtement 55 (figure 7).

Le deuxième revêtement 55 peut être un revêtement anti-rayures qui permet de protéger la face externe contre des rayures pouvant être provoquées par le frottement du téléphone 10 sur d'autres objets.

De façon à faciliter la visualisation des informations sur l'écran 14 dans toutes les circonstances, quel que soit l'angle d'incidence de la lumière par rapport à la face externe 24 du corps 22, le deuxième revêtement 55 peut être un revêtement anti-reflets.

La figure 7 représente un deuxième mode de réalisation préféré de l'invention.

Le boîtier de protection 12 est constitué d'un corps 22 transparent dont les moyens de fixation 34 avec la coque supérieure 18 comportent un insert 56 qui est avantageusement de forme annulaire.

L'insert est de forme complémentaire de celle du rebord étagé 28. Il est délimité par une face inférieure horizontal 57 qui est en appui sur la zone 32 de rebord 28, et par une face supérieure 59 inclinée de l'angle ∝ conformément à l'invention. L'insert 56 est ainsi interposé verticalement entre le rebord 28 et l'écran 22.

L'insert 56 est masqué vers l'extérieur par le premier revêtement de décoration 38 qui s'étend en regard de sa face supérieure inclinée 59.

L'insert 56 comporte des pions 58 qui s'étendent sensiblement verticalement vers l'intérieur du boîtier 12 et qui coopèrent avec des orifices 60 réalisés dans le rebord 28 de la coque supérieure 18.

Les pions 58 permettent de positionner et de fixer le corps 22 par rapport à la coque supérieure 18.

Les pions 58 peuvent être collés à l'intérieur des orifices 60 de façon à assurer la fixation du corps 22 sur la coque supérieure 18.

Selon une variante, les pions 58 peuvent être engagés à force dans les orifices 60, ou sertis à chaud.

L'invention propose aussi un outillage 70 pour la fabrication du boîtier de protection 12 selon le deuxième mode de réalisation, avec insert, de l'invention. L'outillage 70 permet notamment de réaliser le moulage de l'insert 56 et le surmoulage du corps 22 en matière transparente, avec interposition du premier revêtement 38.

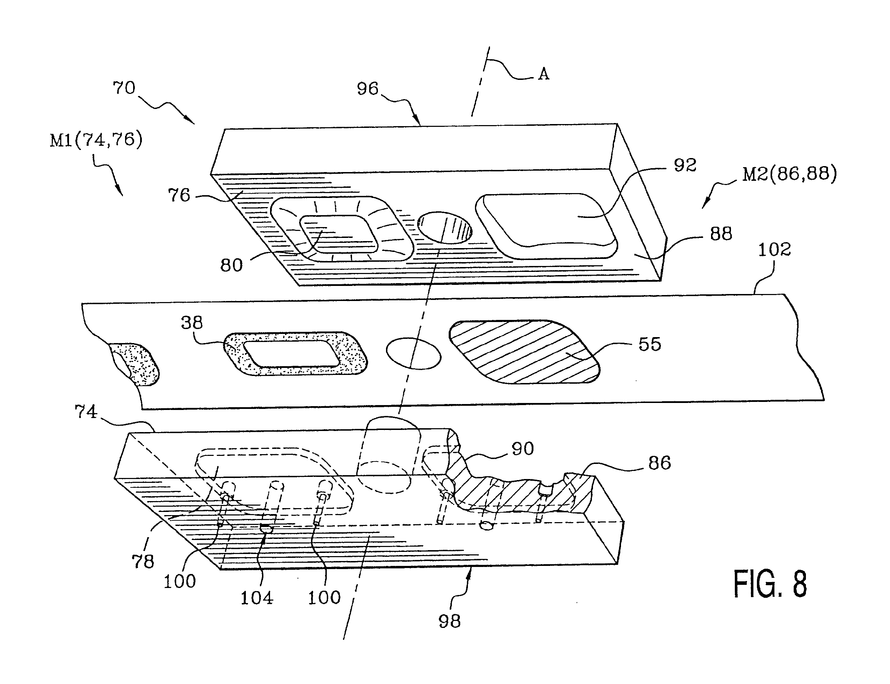

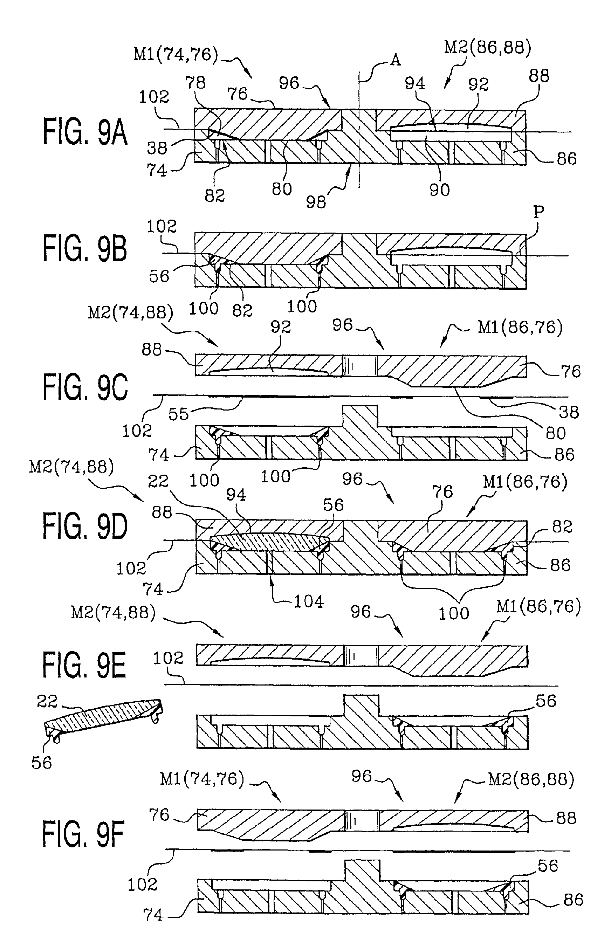

L'outillage 70 représenté aux figures 8 et 9A à 9F comporte deux moules.

Conformément notamment aux figures 8, 9A et 9B, un premier moule M1 est constitué d'une première matrice inférieure 74 et d'une première matrice supérieure 76 comportant chacune une empreinte 78 et 80 respectivement, de façon à délimiter une première cavité 82 dans laquelle l'insert 56 est réalisé par moulage.

Le premier moule M1 est alors désigné sur les figures par la référence M1(X, Y) dans laquelle X et Y correspondent à la référence des matrices supérieure et inférieure correspondantes respectivement.

Conformément notamment aux figures 8, 9A et 9B un deuxième moule M2 est constitué d'une deuxième matrice inférieure 86 et d'une deuxième matrice supérieure 88 comportant chacune une empreinte 90, 92 respectivement de façon à délimiter une deuxième cavité 94 dans laquelle est transféré l'insert 56 et sur lequel le corps transparent 22 est surmoulé.

De façon similaire au premier moule M1, le deuxième moule M2 est alors désigné sur les figures par la référence M2(X, Y) dans laquelle X et Y correspondent à la référence des matrices inférieure et supérieure correspondantes respectivement.

Conformément à l'invention, la première matrice inférieure 74 et la deuxième matrice inférieure 86 comportent chacune une empreinte 78 et 90 identiques.

De plus, les première et deuxième matrices inférieures 74 et 86 sont mobiles par rapport aux première et deuxième matrices supérieures 76 et 88.

Avantageusement, conformément aux figures 8 et 9A à 9F la première et la deuxième matrices supérieures 76 et 88 sont réalisées sous la forme d'une matrice supérieure commune 96 comportant deux empreintes 80 et 92. De même la première et la deuxième matrices inférieures 74 et 86 sont réalisées sous la forme d'une matrice inférieure commune 98 comportant les deux empreintes 78 et 90.

La matrice supérieure commune 96 est montée pivotante autour d'un axe vertical A orthogonal au plan de joint horizontal P des moules de façon que son pivotement de 180° permette la coopération alternative de chacune des deux empreintes 80 et 92 avec chacune des deux empreintes 78 et 90 des deux autres matrices 74 et 86, respectivement.

L'utilisation de l'outillage 70 va être explicitée par la description du procédé de fabrication du boîtier de protection 12 selon le deuxième mode de réalisation.

Selon ce procédé, on réalise l'insert 56 par moulage d'une première matière dans une première cavité 82, délimitée par les empreintes 78 et 80 de deux matrices 74 et 76 du premier moule M1.

Au début du processus de production, les première et deuxième cavités 82 et 94 des premier et deuxième moules M1 et M2 sont vides conformément à la figure 9A.

Conformément à la figure 9B, une première matière plastique est injectée dans la première cavité 82 par des canaux 100 qui traversent la première matrice inférieure 74 de façon à réaliser l'insert 56.

Avantageusement, lors de la réalisation de l'insert 56, le premier revêtement de décoration 38 est déposé sur la zone de l'insert associée à la zone périphérique de fixation 30 du corps transparent 22.

Le dépôt du premier revêtement 38 est réalisé par transfert à partir d'un film 102 qui s'étend dans la cavité 82 du premier moule M1.

Le film 102 peut être en plastique qui résiste à la chaleur. Le premier revêtement 38 est déposé sur la face du film 102 qui est orientée, vers le bas vers la première matrice inférieure 74 lors de la réalisation de l'insert 56.

L'adhésion entre le premier revêtement 38 et le film 102 est telle que lorsque la première matière plastique chaude est injectée dans la première cavité 82, la chaleur provoque le décollement du premier revêtement 38 du film 102. Ainsi, le premier revêtement 38 se "dépose" sur la partie de l'insert 56 avec laquelle il est en contact.

Ensuite, la matrice supérieure commune 96 est décalée vers le haut de façon à ouvrir les moules M1 et M2, puis elle pivote de 180 degrés autour de l'axe A, conformément à la figure 9C.

Le premier moule M1 est alors constitué par la première matrice inférieure 74 et la deuxième matrice supérieure 88 et le deuxième moule M2 est constitué par la deuxième matrice inférieure 86 et la première matrice supérieure 76.

Le film 102 est translaté horizontalement de façon que le premier revêtement de décoration 38 soit en vis-à-vis de l'empreinte 80 de la première matrice supérieure 76, et de façon qu'un deuxième revêtement 55, par exemple le revêtement de protection anti-rayures 55 soit en vis-à-vis de l'empreinte 92 de la deuxième matrice supérieure 88.

La matrice supérieure commune 96 est alors décalée vers le bas de façon à fermer les moules M1 et M2.

La première matrice supérieure 76 est alors en vis-à-vis de la deuxième matrice inférieure 86 de façon à former la première cavité 82, et la deuxième matrice supérieure 88 est en vis-à-vis de la première matrice inférieure 74 de façon à former la deuxième cavité 94, conformément à la figure 9D.

Lorsque les moules M1 et M2 sont fermés, on injecte de la première matière plastique par les canaux 100 de la deuxième matrice inférieure 86 dans la première cavité 82 de façon à réaliser l'insert 56.

Concomitamment, on injecte de la matière plastique transparente par le canal central 104 de la première matrice inférieure 74 dans la deuxième cavité 94 de façon à surmouler le corps 22 en matière transparente sur l'insert 56 réalisé à l'étape précédente.

Lors de cette étape, les revêtements de décoration 38 et de protection déposés sur le film 102 sont transférés sur les zones correspondantes de l'insert 56 et du corps 22 respectivement.

Ainsi, le procédé permet de réaliser concomitamment un insert 56 et de surmouler le corps 22 sur un insert 56 réalisé à l'étape précédente.

La figure 9E représente l'ouverture du premier et du deuxième moules M1 et M2, et l'éjection du corps 22 surmoulé sur l'insert 56.

Ensuite conformément à la figure 9F, la matrice supérieure commune 96 pivote à nouveau de 180 degrés dans une position identique à celle représentée à la figure 9A.

Le procédé se poursuit ainsi permettant lors de chaque ouverture des moules M1 et M2 de réaliser un insert 56 et de surmouler un corps 22 sur un insert 56 déjà réalisé.

De façon à translater facilement le film 102 à chaque ouverture des moules M1 et M2, il peut être enroulé sur deux bobines, non représentées, qui sont situées de part et d'autre de l'outillage 70.

L'une d'entre elles permet en se déroulant d'alimenter l'outillage 70 en revêtements. L'autre permet de stocker le film 102 en le rembobinant.

## Revendications

1. Boîtier de protection (12) d'un appareil électronique (10) du type qui comporte une coque (18) dans laquelle est réalisée une ouverture (20) obturée par un corps (22) en matière transparente de forme générale plane, du type dans lequel au moins une zone annulaire périphérique interne de fixation (30) du corps (22) transparent est fixée sur une zone (32) en vis-à-vis de la périphérie de l'ouverture (20) par des moyens de fixation et/ou de positionnement (34) avec interposition d'un premier revêtement de décoration (38) entre la zone périphérique (30) de fixation du corps (22) transparent et les moyens de fixation et/ou de positionnement (34),
**caractérisé en ce que** la zone périphérique de fixation (30) est inclinée par rapport au plan général du corps (22) transparent.

2. Boîtier de protection (12) selon la revendication précédente, **caractérisé en ce que** la zone périphérique de fixation (30) inclinée s'étend sur la totalité du pourtour du corps (22) transparent.

3. Boîtier de protection (12) selon l'une quelconque des revendications 1 ou 2, **caractérisé en ce que** la face externe (24) sensiblement plane du corps (22) transparent est revêtue au moins partiellement d'un deuxième revêtement (55), notamment un revêtement de protection, par exemple anti-rayures, de la face externe (24) du corps (22) transparent.

4. Boîtier de protection (12) selon l'une quelconque des revendications précédentes, **caractérisé en ce que** les moyens de fixation et/ou de positionnement (34) comportent une couche de colle (35).

5. Boîtier de protection (12) selon l'une quelconque des revendications précédentes, **caractérisé en ce que** les moyens de fixation et/ou de positionnement (34) comportent au moins un insert (56), et **en ce que** le premier revêtement (38) masque au moins partiellement l'insert (56).

6. Boîtier de protection (12) selon l'une quelconque des revendications précédentes, **caractérisé en ce que** l'angle d'inclinaison de la zone périphérique de fixation (30) est de l'ordre de 30° par rapport au plan général du corps (22) transparent.

7. Procédé de fabrication d'un boîtier de protection (12) selon la revendication précédente, **caractérisé en ce que** : on réalise l'insert (56) par moulage d'une première matière dans une première cavité (82), délimitée par les empreintes (78, 80) de deux matrices (74, 76) d'un premier moule (M1) ; puis on transfère l'insert (56) dans une deuxième cavité (94), délimitée par les empreintes (90, 92) de deux matrices (86, 88) d'un deuxième moule (M2), dans laquelle on injecte une seconde matière transparente de façon à réaliser le corps (22) transparent par surmoulage de la deuxième matière sur l'insert (56).

8. Procédé de fabrication selon la revendication précédente, **caractérisé en ce que**, lors de la réalisation de l'insert (56), le premier revêtement de décoration (38) est déposé sur la zone de l'insert (56) complémentaire de la zone périphérique de fixation (30) du corps (22) transparent, par transfert du premier revêtement de décoration (38) qui appartient à un film (102) qui s'étend dans la cavité (82) du premier moule (M1).

9. Procédé de fabrication selon l'une des revendications 7 ou 8 prise en combinaison avec la revendication 3, **caractérisé en ce que**, lors du surmoulage du corps (22) transparent, le deuxième revêtement (55) est déposé sur au moins une partie de la face externe (24) du corps (22) par transfert du deuxième revêtement (55) qui appartient à un film (102) qui s'étend dans la cavité (94) du deuxième moule (M2).

10. Outillage pour la fabrication d'un boîtier de protection (12) selon l'une des revendications 5 ou 6 du type qui comporte :
un premier moule (M1) constitué d'une première matrice inférieure (74) et d'une première matrice supérieure (76) comportant chacune une empreinte (78, 80) de façon à délimiter une première cavité (82) dans laquelle est réalisé l'insert (56), et
un deuxième moule (M2) constitué d'une deuxième matrice inférieure (86) et d'une deuxième matrice supérieure (88) comportant chacune une empreinte (90, 92) de façon à délimiter une deuxième cavité (94) dans laquelle est transféré l'insert (56) sur lequel le corps (22) transparent est surmoulé,
**caractérisé en ce que** la première matrice inférieure (74) et la deuxième matrice inférieure (86) comportent chacune une empreinte (78, 90) identique.

11. Outillage selon la revendication précédente, **caractérisé en ce que** les première et deuxième matrices supérieures (76, 88) sont mobiles par rapport aux première et deuxième matrices inférieures (74, 86).

12. Outillage selon l'une des revendications 10 ou 11, **caractérisé en ce que** les première et deuxième matrices supérieures (76, 88) sont réalisées en une matrice supérieure commune (96) comportant deux empreintes (80, 92), **en ce que** les première et deuxième matrices inférieures (74, 86) sont réalisées en une matrice inférieure commune (98) comportant deux empreintes (78, 90) et **en ce qu'**une matrice commune (96) est montée pivotante autour d'un axe (A) orthogonal au plan de joint (P) des moules (M1, M2) de façon que son pivotement de 180° permette la coopération alternative de chacune de ces deux empreintes (80, 92) avec chacune des empreintes (78, 90) des deux autres matrices (74, 86).

13. Appareil électronique comportant un boîtier selon l'une des revendications 1 à 6.
